# EUROPEAN PATENT APPLICATION

(11) **EP 4 521 168 A1**
(43) Date of publication of application: **12.03.2025**
(21) Application number: 23195431.4
(22) Date of filing: 05.09.2023
(51) Int. Cl.: G03F 7/00, G03F 9/00

(54) **METHOD OF DETERMINING A POSITIONING CORRECTION FOR A LITHOGRAPHIC PROCESS**

(71) Applicant: ASML Netherlands B.V., 5500 AH Veldhoven (NL)
(72) Inventor: JIN, Wenjie, 5500 AH Veldhoven (NL); LENTZEN, Sven, Servaas, Klarinus, 5500 AH Veldhoven (NL)
(74) Representative: ASML Netherlands B.V.

(57) **Abstract**

Disclosed is a method of determining a positioning correction of a substrate in a lithographic process. The method comprises obtaining a trained first model, the trained first model having been trained to minimize a force balance residual of forces on a substrate subsequent to performing at least one action resulting in a physical deformation of said substrate, said physical deformation being impacted by nonlinear frictional interaction between the substrate and a substrate support supporting the substrate, for various training datasets; obtaining estimated substrate deformation data relating to the substrate; inputting said estimated substrate deformation data into said trained first model to obtain modeled substrate deformation data relating to said substrate subsequent to said action, said modeled substrate deformation data accounting for said nonlinear frictional interaction between the substrate and the substrate support; and determining a positioning correction of said substrate in an exposure using said modeled substrate deformation data.

## Description

### BACKGROUND

### FIELD OF THE INVENTION

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor.

### BACKGROUNT ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Positioning corrections are determined to correct for substrate deformation based on alignment metrology. Alignment metrology typically comprises measuring alignment marks on a substrate and fitting as model to the resultant alignment data, the model describing the substrate deformation. For best accuracy, it would be desirable to measure many more alignment marks as is practical from a throughput and/or wafer area perspective.

It would be desirable to improve on methods for determining substrate deformation.

### SUMMARY OF THE INVENTION

The invention in a first aspect provides a method of determining a positioning correction of a substrate in a lithographic process, the method comprising: obtaining a trained first model, the trained first model having been trained to minimize a force balance residual of forces on a substrate subsequent to performing at least one action resulting in a physical deformation of said substrate, said physical deformation being impacted by frictional interaction between the substrate and a substrate support supporting the substrate, for various training datasets; obtaining estimated substrate deformation data relating to the substrate; inputting at least said estimated substrate deformation data into said trained first model to obtain at least modeled substrate deformation data relating to said substrate subsequent to said at least one action, said modeled substrate deformation data accounting for said frictional interaction between the substrate and the substrate support; and determining a positioning correction of said substrate in an exposure using said modeled substrate deformation data.

Also disclosed is a computer program and lithographic apparatus being operable to perform the method of the first aspect.

The above and other aspects of the invention will be understood from a consideration of the examples described below.

### BRIEF DESCRIPTION OF THE DRAWINGS

Embodiments of the invention will now be described, by way of example only, with reference to the accompanying drawings, in which:
Figure 1 depicts a schematic overview of lithographic apparatus;
Figure 2 depicts a schematic overview of a lithographic cell;
Figure 3 illustrates schematically measurement and exposure processes in the apparatus of Figure 1;
Figure 4 depicts a schematic representation of holistic lithography, representing a cooperation between three key technologies to optimize semiconductor manufacturing;
Figure 5 is a schematic illustration of an alignment sensor adaptable according to an embodiment of the invention;
Figure 6 is a flowchart describing a method of training a model for obtaining a high resolution wafer deformation map from low resolution alignment data according to an embodiment; and
Figure 7 is a flowchart describing a method of using the model trained according to the method of Figure 6 to obtain a high resolution wafer deformation map from low resolution alignment data according to an embodiment.

### DETAILED DESCRIPTION OF EMBODIMENTS

Before describing embodiments of the invention in detail, it is instructive to present an example environment in which embodiments of the present invention may be implemented.

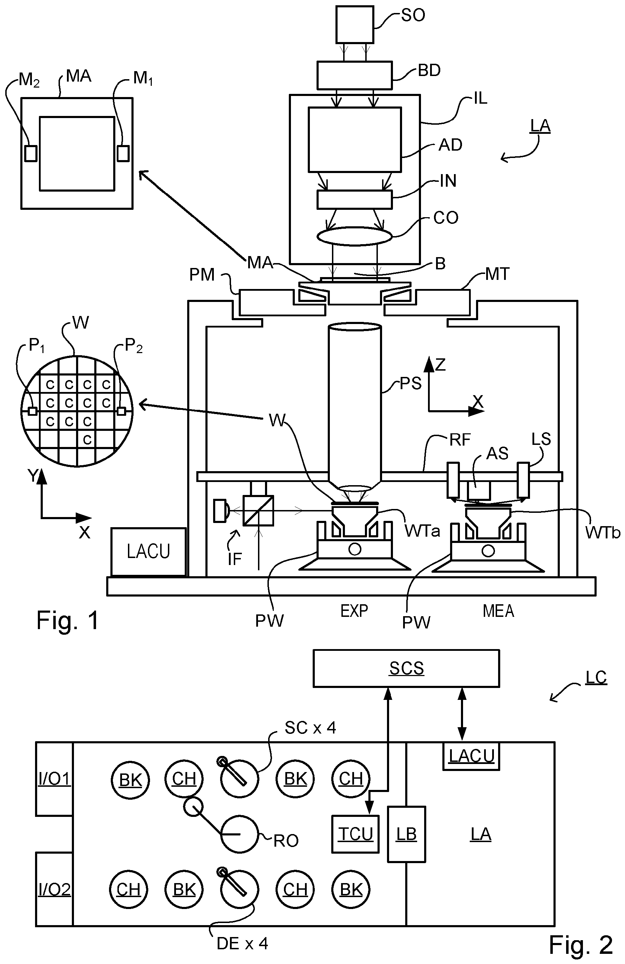

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA may be of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

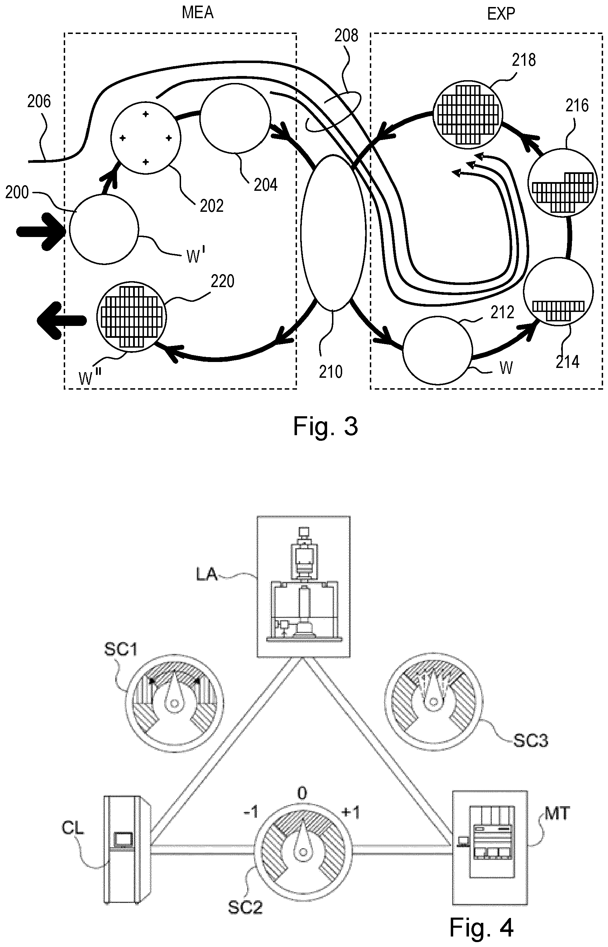

Figure 3 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a `dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Figure 4. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 4 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 4 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 4 by the multiple arrows in the third scale SC3).

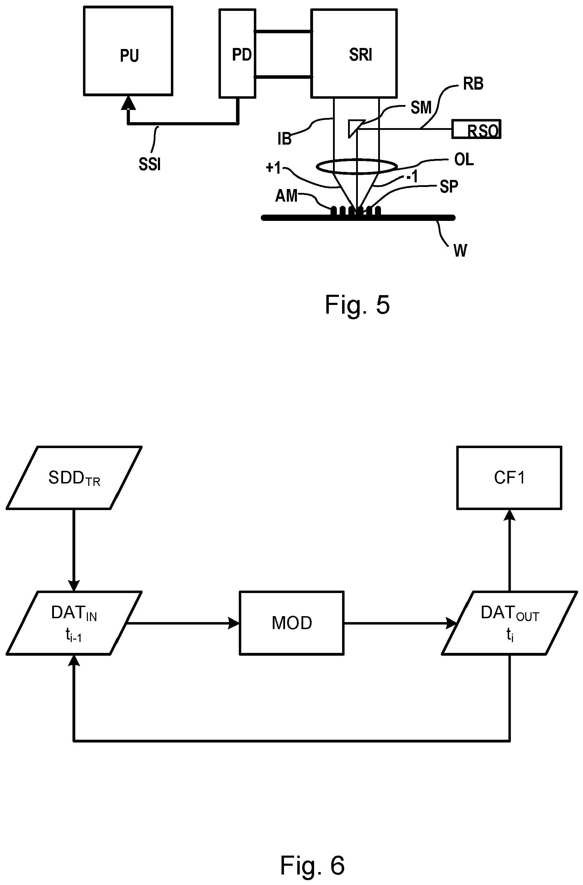

Figure 5 is a schematic block diagram of an embodiment of a known alignment sensor AS. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include complementary higher diffracted orders; e.g.,: +1 and -1 diffracted orders (labelled +1, -1) and optionally zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

SRI Intensity signals SSI are supplied to a processing unit PU. By a combination of optical processing in the self-referencing interferometer SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths for increased accuracy and/or for robust detection of the mark irrespective of the materials from which the mark is made, and materials on and/or below which the mark is provided. Improvements in performing and processing such multiple wavelength measurements are disclosed below.

As has been described, alignment data, which describes the measured XY positions (substrate plane positions) of each alignment mark, is used to fit an alignment model e.g., which comprises a set of polynomials. The fitted model approximately describes the substrate deformation over the whole wafer, and is used as an input for a subsequent exposure on the substrate for overlay correction.

The accuracy of the fitted model depends *inter alia* on the number of alignment marks measured (e.g., the measurement density): the model accuracy increases with increased measurement density (at least to a point). However, simply increasing the number of marks measured is not feasible in practical high-volume manufacturing (HVM) as each measurement takes time, and measuring as many marks as would be desirable in terms of modeling accuracy would take too long in an HVM environment. Additionally, each mark takes significant space on a wafer (comprising of course a finite area), therefore imposing a limitation on the practical number of marks which may be accommodated and therefore imposing a further limitation on the practical maximum measurement density.

Methods are disclosed herein for obtaining high resolution deformation data from low resolution or low density alignment data; e.g., alignment data obtained from a typical number of marks as presently measured in HVM, e.g., less than 80, less than 70 or less than 60 marks per wafer. Such a method may be used to effectively improve wafer alignment without increasing the number of alignment marks/measurements.

The high resolution deformation data will largely depend on an unknown initial unclamped substrate shape or unknown (high resolution) unclamped substrate deformation data (and other unknown physical parameters). The method may comprise using the trained first model to model clamping of the substrate and therefore estimate the clamped substrate shape at high resolution, i.e., (high resolution) clamped substrate deformation data, from the (unknown) unclamped substrate deformation data.

In an embodiment, this may comprise beginning with initial estimated substrate deformation data, e.g., an initial estimate of the unclamped substrate deformation data (e.g., and substrate physical parameters), and using the trained first model to estimate the clamped substrate deformation data from the unclamped substrate deformation data. An optimization may be performed to optimize (e.g., iteratively or using a second trained model) the unclamped substrate deformation data (e.g., and optionally the unclamped substrate physical parameters) so as to minimize differences between the clamped substrate deformation data as modeled and the alignment data (optionally including level sensor data in a 3D deformation embodiment) as measured at the measurement (alignment mark) locations. Once optimized, the final clamped substrate deformation data may be used as high-resolution substrate deformation data in place of conventional fitted alignment data (e.g., sampled at a higher resolution than said conventional fitted alignment data).

Substrate physical parameters in this context may comprise, for example, one or more of *inter alia* burl stiffness, coefficient of friction, backfill gas pressure, substrate/substrate support temperature, burl contact data, friction model data. These are parameters which are or may becomprised in a physical wafer load grid (WLG) model (which has been developed but is very slow to arrive at a solution) and relate to the thermal-mechanical description of the substrate-clamp interaction. The physical WLG model aims to minimize the force balance residual, describing the balance of forces on the substrate, iteratively. This physical WLG model arrives at a solution over a time period on the scale of hours. In the methods disclosed herein, the first model may be trained by inputting the first model output into the physical WLG model equations and minimizing a resultant force balance residual. Because the first model uses the same governing equations as the physical model, these physical parameters can be either be fixed constant or set as variables and to become an input to the first model, such that they can then be inferred with the unclamped substrate deformation data using the metrology data (e.g., in a fitting step as described).

Briefly, WLG is a distortion in overlay, related to unflatness of the substrate (wafer) during clamping and finite friction coefficient between burls and substrate, where burls are projections on the substrate support (wafer table) on which the substrate is supported. A perfect loading of a substrate onto a substrate support implies that no strain remains in the loaded substrate once it fully lies on (and is clamped to) the plurality of burls. Any strain locked into the substrate may deform the substrate in the XY plane and thereby cause overlay errors. Local sliding of the substrate may take place when loading the substrate onto the substrate support. The residual deformations in the substrate caused by this local sliding contributes to the overlay error. The WLG is a metric for quantifying the error introduced by this deformation.

Wafer clamping may comprise a sequence of wafer loading from e-pins to the substrate holder or wafer table. Such a process may comprise carrying the substrate on the e-pins downward to the substrate table, the substrate touches the substrate holder and is clamped on the substrate holder (e.g., by vacuum or electrostatically depending on the scanner type) such that stresses are locked into the substrate.

The proposed method may use a trained first model, such as a neural network model, having been trained to determine modeled substrate deformation data such as modeled clamped substrate deformation data, e.g., a high resolution wafer deformation map, (e.g., and physical parameters) from estimated substrate deformation data such as estimated unclamped substrate deformation data.

Alternatively, or in addition, the trained first model may model wafer heating induced deformation (i.e., wafer heating induced expansion). This may be done in parallel with the WLG modeling, e.g., modeling the wafer from an unclamped to clamped state while accounting for any heat load on, and resultant expansion of, the substrate. Alternatively, the trained first model may enable real-time prediction of (e.g., EUV) exposure induced wafer deformation in isolation from WLG modeling. During exposure (after clamping) the wafer will again deform due to the (e.g., EUV) heat load exposing each die. Predicting this wafer deformation/expansion in real-time enables feed-forward corrections to be determined for the exposure. In either case, the first model may receive as an input temperature data (e.g., from a temperature sensor of the lithographic apparatus such as a substrate support temperature sensor. In an embodiment, this temperature data may be input into a linear wafer heating or linear wafer expansion model to obtain linear expansion data, and the first model used to translate this linear expansion data to non-linear expansion data better reflecting the actual expansion of the substrate accounting for frictional interaction between substrate and substrate support. In the WLG embodiment, this temperature data or linear expansion data may be provided in parallel the estimated unclamped substrate deformation data. Such a linear wafer expansion or wafer heating (WH) model is presently used on some lithographic apparatuses, and assumes linear wafer expansion over time. Because of this, the presently used linear WH model suffers in terms of accuracy as many of the mechanisms being modeled are highly nonlinear; in particular the aforementioned non-linear frictional interaction between substrate and substrate support. A physics based nonlinear WH model has been developed which includes modeling of the substrate touchdown mechanics and nonlinear burl friction effects. However this model has not yet been deployed in HVM due to it being impractically slow to come to a solution (e.g., on the order of hours per substrate).

The trained first model in any of these embodiments may model the deformation or distortion over time (e.g., during the clamping procedure) by determining the distortion over multiple time points in sequence, with the output of each timestep being used as the input for the next timestep. The trained first model may solve the physics relating to the non-linear frictional interaction between substrate and substrate support during wafer clamping (e.g., due to burl friction effects between the substrate backside and burls) and optionally other factors such as thermal load (distortion due to change in wafer temperature) and/or friction model data.

The method may comprise obtaining a trained first model, the trained first model having been trained to minimize a force balance residual of forces on a substrate subsequent to performing at least one action resulting in a physical deformation of said substrate, said physical deformation being impacted by nonlinear frictional interaction between the substrate and a substrate support supporting the substrate, for various training datasets; obtaining estimated substrate deformation data relating to the substrate; inputting at least said estimated substrate deformation data into said trained first model to obtain at least modeled substrate deformation data relating to said substrate subsequent to said at least one action, said modeled substrate deformation data accounting for said nonlinear frictional interaction between the substrate and the substrate support; and determining a positioning correction of said substrate in an exposure using said modeled substrate deformation data.

In a more specific embodiment, the method may comprise: obtaining a trained first model, the trained first model having been trained to minimize a force balance residual of forces on a clamped substrate subsequent to clamping of said substrate onto a substrate support for various unclamped substrate deformation datasets (e.g., various unclamped substrate shapes); obtaining metrology data (e.g., alignment data) relating to said substrate; obtaining estimated unclamped substrate deformation data relating to the substrate prior to said clamping; inputting at least said estimated unclamped substrate deformation data into said trained first model to obtain at least estimated clamped substrate deformation data relating to said substrate subsequent to clamping; determining final unclamped substrate deformation data which minimizes a difference between estimated clamped substrate deformation data as estimated by said first model and said metrology data; performing a positioning operation of said substrate in a subsequent exposure using output substrate deformation data, said output substrate deformation data comprising the estimated clamped substrate deformation data corresponding to the final unclamped substrate deformation data (e.g the estimated clamped substrate deformation data corresponding to the final unclamped substrate deformation data may be an input-output pair for said first model). The output substrate deformation data may comprise a higher resolution than said metrology data.

In addition to substrate deformation data, the method may comprise inputting estimates for other substrate physical parameter data into said trained first model, such as has already been described.

The optimization may also optimize the unclamped substrate deformation data and therefore the output substrate deformation data in the direction perpendicular to the substrate plane (Z-direction). This may comprise parameterizing the (unclamped and clamped) substrate deformation data wafer in 3 dimensions and performing the optimization with respect to both alignment data and level sensor data (substrate height data). As such the optimization may minimize the difference between the estimate clamped substrate deformation data in this Z-direction and known values from level sensor data. As such, the method may also comprise obtaining level sensor data.

The method may comprise using the trained first model in multiple timesteps during a clamping period during which said substrate is clamped (i.e., goes from an unclamped configuration to a fully clamped configuration), with the model output from the (immediately) previous timestep used as an input to the trained first model for each successive timestep.

At each timestep, the first model may output at least substrate deformation data describing the deformation of that substrate for that timestep. In addition, the first model may output burl contact data and/or friction model data. Burl contact data may describe an order or sequence of burl contact with the substrate during clamping (e.g., the order in which the burls of substrate table contact the wafer). Friction model data may describe the friction model of the substrate, i.e., where the substrate is in a plot of frictional forces over time (e.g., is the force has been increasing or decreasing and at what rate). As is known, friction force depends on its history (hysteresis) and a non-linear model can be used to describe such behavior, for example a Maxwell friction model. A suitable friction model is described in . Al-Bender et al., Theoretical analysis of the dynamic behavior of hysteresis elements in mechanical systems, Int. J. Non-Lin. Mech. 39 (2004) 1721 - 1735, which is incorporated herein by reference.

A trained second model may be used to determine the unclamped substrate deformation data and/or initial WLG physical model parameters from the metrology data using the data set generated by trained first model, for a fast inference. The first trained model may provide fast mapping from initial unclamped states to final clamped states. For a given measurement data, it is possible to perform a back propagation (gradient descent) to optimize the initial states; however, this might take longer than is ideal since it requires multiple iterations. An alternative is to train a second model or second neural network to directly learn the mapping from final clamped states to initial unclamped states, by making use of the 1000x faster data generation enabled by the trained first model.

The trained first model (and trained second model) may comprise a machine learning model such as a neural network.

The trained first model may also model other effects such as thermal effects (thermal expansion). In such an embodiment, the trained model may recover the correct nonlinear substrate thermal expansion (i.e., accounting for the non-linear friction effects) from the linear thermal expansion, e.g., as determined from the linear WLG model which ignores the friction effects such that the wafer and clamp are modeled together as one rigid body.

The training of the first model does not use a typical "black box" machine learning approach where input-output paired training data (i.e., labelled training data) is used to teach the model to map from input to output. Instead the first model may be trained by directly substituting the first model output into the governing equations of the WLG physical model, i.e., the force balance, and minimizing the residual of the force balance, e.g., using a suitable cost function. Therefore, this residual is defined as the cost function. The force balance equation(s) may comprise the same equations as has been developed for the aforementioned non-linear WLG and WH physical model, which has been developed but is too slow to reach a solution for HVM use. Since the correct solution should render zero residual (the substrate is stationary), by minimizing the loss function the first model output is by definition physically correct. Since the forward calculation of the first model is very fast, a significant reduction of the computation time is foreseeable compared to iteratively solving using the physical non-linear WLG or WH model.

The training may be performed over multiple timesteps over the deformation process, with the first model output of the previous timestep being used as a first model input for the next timestep.

The first model may be trained with many different initial wafer shapes by randomly sampling the input vector comprising unclamped substrate distortion data. Depending on the data availability, it is also possible to encode information of the process fingerprint into the input vector. A key point is that, unlike the conventional deep learning methods where many input output pairs are required for training (computationally demanding and almost impossible for slow solvers), here the training is done by directly imposing the physical laws onto the output and taking the residual as the cost function. Because of this, the training data is simple and cheap to generate, e.g., random shape descriptions, random linear thermal expansion maps etc..

Figure 6 is a flowchart illustrating a method for training the first model. Training (unclamped) substrate deformation data SDD_{TR} is obtained. The training substrate deformation data SDD_{TR} may by parameterized by an input vector comprising multiple elements. The training substrate deformation data SDD_{TR} may be generated for many different shapes (e.g., by measurement and/or simulation). This can be simulated, for example, by randomly sampling the input vector. This training data does not need labeling and/or any output pairs. The substrate deformation data may describe deformation in the substrate plane and optionally also normal to the substrate plane. The training data may also optionally include thermal expansion data if thermal expansion effects are to be modeled.

The training substrate deformation data SDD_{TR} may be used to derive input data DAT_{IN}, comprising in addition to the substrate deformation data. The input data DAT_{IN} may further comprise WLG physical model parameters. The WLG physical model parameters may comprise, for example, such as one or more of temperature data, linear expansion data, burl contact data, friction model data, burl stiffness data, coefficient of friction data, backfill gas pressure data. The input data DAT_{IN}, corresponding to a time tᵢ₋₁ is input to the first model MOD, and the model MOD is trained to estimate the equivalent data DAT_{OUT} at a later time point tᵢ during clamping which minimizes a cost function CF1 for which the force balance is the cost to be minimized, e.g., the burl to wafer force at each timestep such that the forces over the wafer sum to zero. This is performed over multiple successive timesteps from the unclamped wafer to the fully clamped wafer, with the output data DAT_{OUT} of the previous timestep used as the input data DAT_{IN} of the next timestep, for all the training substrate deformation data SDD_{TR}. In this way, the trained first model MOD will be able to estimate the distortion (in 2 or 3 dimensions) within a clamped wafer, for many different unclamped wafer shapes.

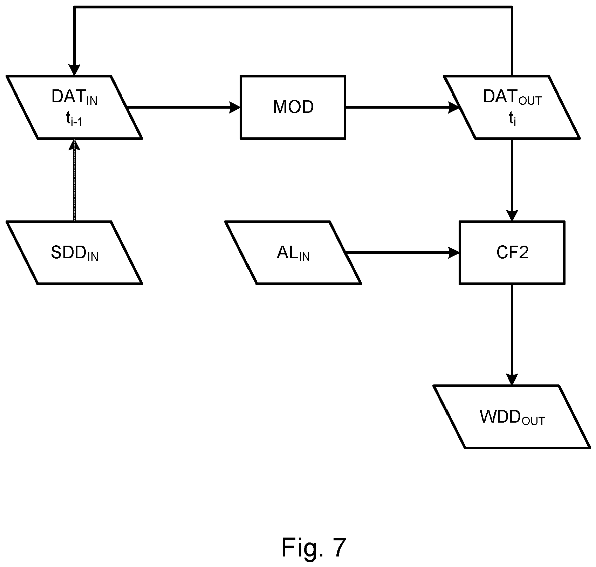

Figure 7 is a flowchart describing using the trained model to obtain high resolution substrate deformation data based on lower resolution alignment data. An initial estimate for the (unclamped) input substrate deformation data SDD_{IN} is obtained, e.g., comprising an initial shape (process fingerprint) which is parameterized by an input vector (comprising multiple elements). The unclamped substrate deformation data SDDar may be used to derive and/or inputted in combination with other input data DAT_{IN} as has been described in relation to Figure 6. The input data DAT_{IN} may also comprise data relating to one or more other WLG physical model parameters, as has been described. In an embodiment, this may include linear expansion data determined using a linear WH model based on a temperature sensor data. This input data SDD_{IN} is fed into the trained first model MOD to obtain substrate deformation data at a later time tᵢ than that tᵢ₋₁ of the input data DAT_{IN}. This may be performed over multiple successive timesteps from the unclamped wafer to the fully clamped wafer, with the output data DAT_{OUT} of the previous timestep used as the input data DAT_{IN} of the next timestep.

The output data DAT_{OUT} is compared to metrology data or alignment data AL_{IN}, such that the measured deformation values within the alignment data AL_{IN} at the mark locations are compared to the distortion values comprised within the output data DAT_{OUT} (comprising estimated clamped substrate deformation data) at the same locations. A cost function CF2 may be used to find input data DATar (e.g., the unclamped substrate distortion data) which minimizes the difference between the output data DAT_{OUT} and alignment data AL_{IN} at the measurement locations. This fitting may optionally also include fitting of one or more of the WLG physical model parameters for the unclamped substrate (alternatively or additionally one or more of these WLG physical model parameters may be fixed at estimated values). Once minimized the final output data WDD_{OUT}, comprising high resolution substrate distortion data, may be used in substrate alignment for a subsequent exposure on that substrate. In an embodiment, level sensor data may be used in combination with the alignment data ALar, to enable a 3D fitting of the substrate deformation.

It can be appreciated that the optimization embodied in cost function CF2 and outlined in Figure 7 is not a model training. The first model MOD is fixed (all parameters fixed) for this optimization, with only the input vector (e.g., and other input physical parameters) fitted. In an embodiment, the cost of cost function CF2 may comprise the mean square error of the mismatch between the output wafer deformation and the alignment measurement at the location of marks. Since cost function CF2 is linked to the unclamped wafer deformation data by the first model, which is fully differentiable, by minimizing CF2 (back-propagation), the unknown input vector (wafer initial shape) evolves to render the best match with the sparse measurement data and at the same time determines the full wafer deformation map.

As such, the proposed first model is a real-time nonlinear solver for the 2D or 3D wafer load grid, simulating the full physical process from any initial wafer shape to fully clamped-down wafer deformation. It enables physics informed wafer alignment, enhancing alignment by the prior knowledge of the wafer load physics. This enables the computation of a high resolution full wafer deformation map from the low resolution alignment measurement without the need to increasing the number of alignment marks. The training of the model does not require expensive (labeled or input-output paired) training data. Instead simple, cheap input-only training data can be used without any corresponding output data or labels.

As has also been described, the first model may be used to determine substrate deformation (expansion) of an already clamped substrate, e.g., during an exposure. This may comprise inputting linear substrate expansion data, such that the first model translates this linear substrate expansion data such that it is corrected for non-linear friction effects. The model may be trained in much the same way as has been described in relation to the WLG embodiment (i.e., minimizing a force balance residual using the same relationships), but with training data comprising various different linear expansion data. Such linear expansion data is cheap to produce and therefore largely varied linear expansion data may be used to train the first model without the need of providing the computationally expensive correct solutions.

The term "optimizing" and "optimization" as used herein refers to or means adjusting a lithographic apparatus, a device manufacturing process, etc. such that results and/or processes of lithography or device manufacturing have more desirable characteristics, such as higher accuracy of projection of a design layout on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Further embodiments of the invention are disclosed in the list of numbered clauses below:
1. A method of determining a positioning correction of a substrate in a lithographic process, the method comprising: obtaining a trained first model, the trained first model having been trained to minimize a force balance residual of forces on a substrate subsequent to performing at least one action resulting in a physical deformation of said substrate, said physical deformation being impacted by frictional interaction between the substrate and a substrate support supporting the substrate, for various training datasets; obtaining estimated substrate deformation data relating to the substrate;
   inputting at least said estimated substrate deformation data into said trained first model to obtain at least modeled substrate deformation data relating to said substrate subsequent to said at least one action, said modeled substrate deformation data accounting for said frictional interaction between the substrate and the substrate support; and determining a positioning correction of said substrate configured to correct an exposure step of the lithographic process using said modeled substrate deformation data.
2. A method according to clause 1, wherein: said at least one action comprises at least clamping of said substrate onto said substrate support; said estimated substrate deformation data comprises estimated unclamped substrate deformation data relating to said substrate prior to said clamping; and said modeled substrate deformation data comprises modeled clamped substrate deformation data relating to said substrate subsequent to said clamping.
3. A method according to clause 2, comprising: obtaining metrology data relating to said substrate; and determining final unclamped substrate deformation data as that for which a difference between the corresponding modeled clamped substrate deformation data as estimated by said first model based on said final unclamped substrate deformation data and said metrology data is minimized.
4. A method according to clause 3, wherein said step of determining a positioning correction comprises determining a positioning correction of said substrate in a subsequent exposure using output substrate deformation data, said output substrate deformation data comprising the modeled clamped substrate deformation data corresponding to the final unclamped substrate deformation data.
5. A method according to clause 3 or 4, wherein said determining final unclamped substrate deformation data comprises performing a fitting of at least the unclamped substrate deformation data in at least a substrate plane, so as to minimize said difference.
6. A method according to clause 5, wherein said performing a fitting further comprises fitting physical parameter data relating to one or more physical parameters of a physical model of interaction between the substrate and substrate support.
7. A method according to any of clauses 3 to 6, wherein the output substrate deformation data has a higher resolution than said metrology data.
8. A method according to any of clauses 3 to 7, wherein said estimated unclamped substrate deformation data, final unclamped substrate deformation data, modeled clamped substrate deformation data and output clamped substrate deformation data are parameterized in at least the substrate plane dimensions.
9. A method according to any of clauses 3 to 8, wherein said determining final unclamped substrate deformation data comprises performing a fitting of the unclamped substrate deformation data in a direction perpendicular to the substrate plane, so as to minimize said difference.
10. A method according to clause 9, wherein said estimated unclamped substrate deformation data, final unclamped substrate deformation data, modeled clamped substrate deformation data and output clamped substrate deformation data are parameterized in three dimensions; and
   said metrology data further comprises substrate height data.
11. A method according to any of clauses 3 to 10, wherein said metrology data comprises at least alignment data.
12. A method according to any preceding clause, wherein said estimated substrate deformation data comprises linear substrate expansion data resulting from a temperature change of said substrate.
13. A method according to clause 12, comprising: obtaining temperature data relating to a temperature of the substrate and/or substrate support; obtaining a linear substrate heating expansion model; and using said linear substrate heating expansion model to generate said linear substrate expansion data from said temperature data.
14. A method according to clause 12 or 13, wherein said method comprises a feedforward correction for heating of said substrate during an exposure.
15. A method according to any preceding clause, comprising using the trained first model in multiple timesteps during a clamping period during which said substrate is clamped, with the model output from the previous timestep used as an input to the trained first model for each successive timestep.
16. A method according to clause 15, wherein said model has been trained to minimize a residual of the force balance at each timestep.
17. A method according to any preceding clause, comprising: obtaining a trained second model; and using the trained second model may be used to determine at least the unclamped substrate deformation data from the metrology data using an output of said trained first model.
18. A method according to any preceding clause, wherein at least the trained first model comprises a machine learning model and/or neural network.
19. A method according to any preceding clause, wherein said trained model models thermal effects on said substrate, said at least said estimated unclamped substrate deformation data further comprising thermal load data.
20. A method according to any preceding clause, comprising a training step to train said first model on training data, said training comprising: Minimizing said force balance residual on the clamped substrate as modeled by said first model for said training data.
21. A method according to clause 20, wherein said training data comprises at least multiple unclamped substrate deformation datasets describing multiple different substrate shapes.
22. A method according to clause 21, comprising randomly generating said training data by randomly sampling an input vector describing said unclamped substrate distortion.
23. A method according to clause 20, 21 or 22, wherein said training data comprises at least multiple substrate expansion datasets relating to multiple different heat loads on said substrate and/or substrate support.
24. A method according to clause 23, comprising generating said training data using a linear substrate heating expansion model.
25. A method according to any of clauses 21 to 24, wherein said training data further comprises physical parameter data relating to one or more physical parameters of a physical model of interaction of the substrate and substrate support.
26. A method according to any of clauses 20 to 25, comprising inputting an output of the first model at each timestep of the training step into the physical wafer load grid model equations and minimizing the resultant force balance residual.
27. A method according to any of clauses 20 to 26, wherein said training data comprises unlabeled training data without corresponding paired output training data.
28. A method according to any preceding clause, further comprising inputting physical parameter data into said trained first model, said physical parameter data relating to one or more physical parameters of a physical model of interaction of the substrate and substrate support.
29. A method according to any preceding clause, comprising performing an exposure on said i substrate based on said positioning correction.
30. A computer program comprising program instructions operable to perform the method of any of clauses 1 to 29, when run on a suitable apparatus.
31. A processing system comprising a processor and a storage device comprising the computer program of clause 30.
32. A lithographic apparatus operable to perform the method of any of clauses 1 to 29.
33. A lithographic apparatus according to clause 32, comprising: an alignment sensor operable to measure at least a portion of said metrology data.
34. A lithographic apparatus according to clause 33, further comprising a level sensor operable to measure at least a portion of said metrology data.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following i claims and their equivalents.

## Claims

1. A method of determining a positioning correction of a substrate in a lithographic process, the method comprising:
obtaining a trained first model, the trained first model having been trained to minimize a force balance residual of forces on a substrate subsequent to performing at least one action resulting in a physical deformation of said substrate, said physical deformation being impacted by frictional interaction between the substrate and a substrate support supporting the substrate, for various training datasets;
obtaining estimated substrate deformation data relating to the substrate;
inputting at least said estimated substrate deformation data into said trained first model to obtain at least modeled substrate deformation data relating to said substrate subsequent to said at least one action, said modeled substrate deformation data accounting for said frictional interaction between the substrate and the substrate support; and
determining a positioning correction of said substrate configured to correct an exposure step of the lithographic process using said modeled substrate deformation data.

2. A method as claimed in claim 1, wherein:
said at least one action comprises at least clamping of said substrate onto said substrate support;
said estimated substrate deformation data comprises estimated unclamped substrate deformation data relating to said substrate prior to said clamping; and
said modeled substrate deformation data comprises modeled clamped substrate deformation data relating to said substrate subsequent to said clamping.

3. A method as claimed in claim 2, comprising:
obtaining metrology data relating to said substrate; and
determining final unclamped substrate deformation data as that for which a difference between the corresponding modeled clamped substrate deformation data as estimated by said first model based on said final unclamped substrate deformation data and said metrology data is minimized.

4. A method as claimed in claim 3, wherein said step of determining a positioning correction comprises determining a positioning correction of said substrate in a subsequent exposure using output substrate deformation data, said output substrate deformation data comprising the modeled clamped substrate deformation data corresponding to the final unclamped substrate deformation data.

5. A method as claimed in any of claims 3 to 4, wherein the output substrate deformation data has a higher resolution than said metrology data.

6. A method as claimed in any of claims 3 to 5, wherein said metrology data comprises at least alignment data.

7. A method as claimed in any preceding claim, wherein said estimated substrate deformation data comprises linear substrate expansion data resulting from a temperature change of said substrate.

8. A method as claimed in claim 7, comprising:
obtaining temperature data relating to a temperature of the substrate and/or substrate support;
obtaining a linear substrate heating expansion model; and
using said linear substrate heating expansion model to generate said linear substrate expansion data from said temperature data.

9. A method as claimed in claim 8, wherein said method comprises generation of a feedforward correction to mitigate heating of said substrate during an exposure step.

10. A method as claimed in any preceding claim, comprising using the trained first model in multiple timesteps during a clamping period during which said substrate is clamped, with the model output from the previous timestep used as an input to the trained first model for each successive timestep.

11. A method as claimed in any preceding claim, comprising:
obtaining a trained second model; and
using the trained second model to determine at least the unclamped substrate deformation data from the metrology data using an output of said trained first model.

12. A method as claimed in any preceding claim, wherein at least the trained first model comprises a machine learning model and/or neural network.

13. A method as claimed in any preceding claim, wherein said trained model models thermal effects on said substrate, said at least said estimated unclamped substrate deformation data further comprising thermal load data.

14. A method as claimed in any preceding claim, further comprising a training step to train said first model on training data, said training comprising minimizing said force balance residual on the clamped substrate as modeled by said first model for said training data.

15. A computer program comprising program instructions operable to perform the method of any of claims 1 to 14, when run on a suitable apparatus.
